# EUROPÄISCHE PATENTSCHRIFT

(11) **EP 2 404 380 B1**
(45) Veröffentlichungstag und Bekanntmachung des Hinweises auf die Patenterteilung: **18.07.2018**
(21) Anmeldenummer: 10707443.7
(22) Anmeldetag: 10.02.2010
(51) Int. Cl.: H03L 7/23, G01R 31/28, G01R 27/28, H03L 7/18

(54) **SYNTHESIZER MIT EINSTELLBARER, STABILER UND REPRODUZIERBARER PHASE UND FREQUENZ**
SYNTHESIZER HAVING ADJUSTABLE, STABLE, AND REPRODUCIBLE PHASE AND FREQUENCY
SYNTHÉTISEUR DOTÉ D'UNE PHASE ET D'UNE FRÉQUENCE RÉGLABLES, STABLES ET REPRODUCTIBLES

(30) Priorität: 05.03.2009 DE 102009011795
(43) Veröffentlichungstag der Anmeldung: 11.01.2012
(73) Patentinhaber: Rohde & Schwarz GmbH & Co. KG, 81671 München (DE)
(72) Erfinder: ORTLER, Georg, 86459 Gessertshausen (DE); EVERS, Christian, 85551 Kirchheim (DE); FREIDHOF, Markus, 85614 Kirchseeon (DE)
(74) Vertreter: Körfer, Thomas
(86) Internationale Anmeldenummer: PCT/EP2010/000809
(87) Internationale Veröffentlichungsnummer: WO 2010/099855

(56) Entgegenhaltungen:
- WO-A1-2007/045388
- WO-A1-2007/124788
- WO-A1-2008/127972
- US-A- 6 163 223
- US-A1- 2007 236 230

## Beschreibung

Die Erfindung betrifft ein Messgerät mit Signalgeneratoren mit einstellbaren, stabilen und reproduzierbaren Phasen und Frequenzen und ein Verfahren zum Betrieb eines Messgeräts zur Erzeugung von Signalen einstellbarer, stabiler und reproduzierbarer Phasen und Frequenzen.

In der Messtechnik, beispielsweise in der Netzwerkanalyse-Messtechnik, wird ein Hochfrequenzsignal für die Speisung des Messobjektes herangezogen. Ein weiteres Hochfrequenzsignal wird als Lokaloszillator-Signal zum Abmischen des empfangenen Generatorsignals in eine geeignete Zwischenfrequenz-Lage eingesetzt. Soll eine komplexe Wellengröße, beispielsweise die am Eingang des Messobjektes reflektierte Welle, nach Betrag und Phase über der Frequenz bestimmt werden, dann müssen die Frequenz- und Phasenverhältnisse der beiden Hochfrequenzsignale nach jedem Frequenzschritt des stufenweise durchlaufenen Messfrequenzbereichs bekannt sein. Ansonsten kann lediglich eine Verhältnismessung durchgeführt werden, bei der die Absolutphase keine Rolle spielt.

Besonders deutlich wird die Problematik, wenn eine Mehrzahl von Signalgeneratoren beteiligt ist, z. B. bei differentiellen Mehrtormessungen, oder bei komplexen umsetzenden Messungen an frequenzumsetzenden Messobjekten, z. B. Mischern. Es sind dann mehrere Signale unterschiedlicher Frequenzen notwendig. Diese werden üblicherweise mittels unabhängiger Signalgeneratoren erzeugt. Ein genaues Frequenzverhältnis und ein genaues Phasenverhältnis der Signale sind dann jedoch nicht länger gegeben.

In der Deutschen Offenlegungsschrift DE 10 2006 003 839 A1 ist mit dem "Secum Trahenz-Verfahren" eine Möglichkeit zur Durchführung komplexer umsetzender Messungen beschrieben. So werden dort die Signalgeneratoren und Lokaloszillatoren ausgehend von einem gemeinsamen Referenzsignal erzeugt. Das Referenzsignal wird von fraktionalen Teilern geteilt. So können beliebige Frequenzen des Referenzsignals erzeugt werden. Durch die fraktionale Teilung geht jedoch die Phasenbeziehung verloren. Die Phasenbeziehung wird erst durch eine Phasenkorrektur wiederhergestellt. Diese ist jedoch sehr langsam und erfordert einen hohen Softwareaufwand. Weiterhin ist nach jedem Frequenzwechsel eine neuerliche Korrektur der Phasen der Signale notwendig. Dies resultiert in einer geringen Messgeschwindigkeit.

US6163223 und WO2007/045388 offenbaren weitere Signalgeneratoren.

Der Erfindung liegt die Aufgabe zu Grunde, ein Messgerät und ein Verfahren zum Betrieb eines Messgeräts zu schaffen, welche bei hoher Messgeschwindigkeit eine genaue Einstellung der Frequenzen und der Phasenbeziehung zumindest zweier Hochfrequenzsignale ermöglichen.

Die Aufgabe wird erfindungsgemäß für das Messgerät durch die Merkmale des unabhängigen Anspruchs 1 und für das Verfahren durch die Merkmale des unabhängigen Anspruchs 8 gelöst. Vorteilhafte Weiterbildungen sind Gegenstand der hierauf rückbezogenen Unteransprüche.

Das erfindungsgemäße Messgerät verfügt über eine Synthesizer-Einrichtung, zumindest zwei Regeleinrichtungen und zumindest zwei gesteuerte Oszillatoren. Die Synthesizer-Einrichtung beinhaltet zumindest einen direkten digitalen Synthesizer und erzeugt zumindest zwei Signale bekannten Phasenverhältnisses. Von der Synthesizer-Einrichtung erzeugte Signale bilden Referenzsignale zumindest einer Regeleinrichtung. Von den Regeleinrichtungen gebildete Signale steuern die gesteuerten Oszillatoren. Das Messgerät beinhaltet lediglich Frequenzteiler, welche durch ganzzahlige Teilungsfaktoren teilen. So wird zuverlässig ein bekanntes Phasenverhältnis der Ausgangssignale erreicht.

Die Synthesizer-Einrichtung beinhaltet bevorzugt genau einen direkten digitalen Synthesizer und erzeugt bevorzugt zumindest zwei Signale identischer Frequenz. So können mit geringem Aufwand Signale identischer Frequenz aber unterschiedlicher Phasenlage erzeugt werden, wie die für differentielle Signalpaare mit 180° Phasendifferenz benötigt wird.

Die Synthesizer-Einrichtung beinhaltet alternativ mehrere direkte digitale Synthesizer und erzeugt mehrere Signale einstellbarer Frequenz. So kann eine hohe Flexibilität erreicht werden und es können verschiedene Signale für frequenzumsetzende Messobjekte erzeugt werden, z. B. ein Eingangssignal und das Oszillatorsignal für einen Mischer als Messobjekt.

Vorteilhafterweise beinhaltet das Messgerät zumindest zwei Frequenzteilungseinrichtungen. Jede Frequenzteilungseinrichtung verarbeitet bevorzugt von einem gesteuerten Oszillator erzeugte Signale. So kann eine besonders hohe Flexibilität der erzeugten Signale erzielt werden.

Jede Frequenzteilungseinrichtung beinhaltet bevorzugt mehrere Frequenzpfade für Signale unterschiedlicher Frequenzbereiche. Jeder Frequenzpfad beinhaltet bevorzugt einen Schalter, welcher den Frequenzpfad auf einen Signalausgang schaltet. Bevorzugt ist gleichzeitig genau ein Frequenzpfad mittels der Schalter auf einen Signalausgang geschaltet. So kann zuverlässig ein Signal einer einzelnen Frequenz ausgewählt werden.

Zumindest ein Frequenzpfad beinhaltet bevorzugt ein Filter. Zumindest ein Frequenzpfad beinhaltet bevorzugt zumindest einen Frequenzteiler, welcher um ganzzahlige Teilerfaktoren teilt. So kann mit geringem Aufwand eine Selektion der Signale durchgeführt werden.

Ein Mischer ist vorteilhafterweise innerhalb eines Frequenzpfades angeordnet. Der Mischer innerhalb des Frequenzpfades mischt bevorzugt das Signal des Frequenzpfads mit einer Taktfrequenz oder einem Vielfachen einer Taktfrequenz herunter. So können insbesondere für niedrige Frequenzen mit geringem Aufwand genaue Ausgangssignale erzielt werden. Erfindungsgemäss beinhalten die Regeleinrichtungen jeweils einen Phasendiskriminator, einen Schleifenregler und zumindest einen Frequenzteiler, welcher um ganzzahlige Teilerfaktoren teilt. Der Frequenzteiler teilt bevorzugt die Frequenz eines von einem gesteuerten Oszillator erzeugten Signals. Der Frequenzteiler überträgt bevorzugt das von ihm erzeugte Signal an den Phasendiskriminator. So wird eine sehr hohe Stabilität des erzeugten Signals innerhalb einer PLL (Phase Locked Loop) -Schleife geschaffen.

Zwischen der Synthesizer-Einrichtung und den gesteuerten Oszillatoren ist bevorzugt zumindest ein Mischer angeordnet. Der Mischer mischt bevorzugt zumindest ein von der Synthesizer-Einrichtung erzeugtes Signal mit einem Taktsignal oder einem Vielfachen eines Taktsignals. So werden die Anforderungen an die Regeleinrichtung reduziert.

Die Synthesizer-Einrichtung erzeugt bevorzugt digitale Signale mit hoher Genauigkeit. Zwischen der Synthesizer-Einrichtung und dem gesteuerten Oszillator ist vorteilhafterweise zumindest ein Analog-Digital-Wandler angeordnet. Der Analog-Digital-Wandler wandelt bevorzugt zumindest ein von der Synthesizer-Einrichtung erzeugtes Signal in zumindest ein analoges Signal. Typischerweise verfügt der Analog-Digital-Wandler über eine geringere Quantisierungs-Genauigkeit als die Synthesizer-Einrichtung. Der Synthesizer-Einrichtung ist deshalb bevorzugt zumindest eine Dithering-Einrichtung nachgeschaltet. Die Dithering-Einrichtung führt dabei ein Dithering zumindest des von der Synthesizer-Einrichtung erzeugten Signals durch. So ist eine sehr genaue Einstellung der Frequenz und Phase des Ausgangssignals möglich.

Nachfolgend wird die Erfindung anhand der Zeichnung, in der ein vorteilhaftes Ausführungsbeispiel der Erfindung dargestellt ist, beispielhaft beschrieben. In der Zeichnung zeigen:
- Fig. 1: ein beispielhaftes Messgerät;
- Fig. 2: ein erstes Ausführungsbeispiel eines Blockschaltbilds des erfindungsgemäßen Messgeräts,
- Fig. 3: ein zweites Ausführungsbeispiel eines Blockschaltbilds des erfindungsgemäßen Messgeräts,
- Fig. 4: eine Detailansicht des ersten und zweiten Ausführungsbeispiels des erfindungsgemäßen Messgeräts, und
- Fig. 5: ein Ausführungsbeispiel des erfindungsgemäßen Verfahrens.

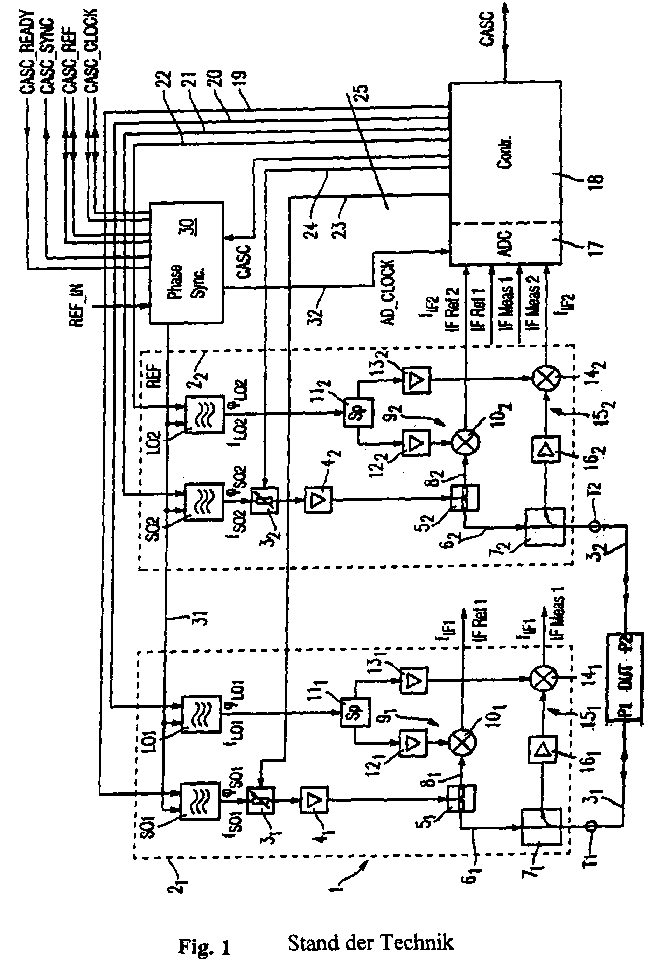

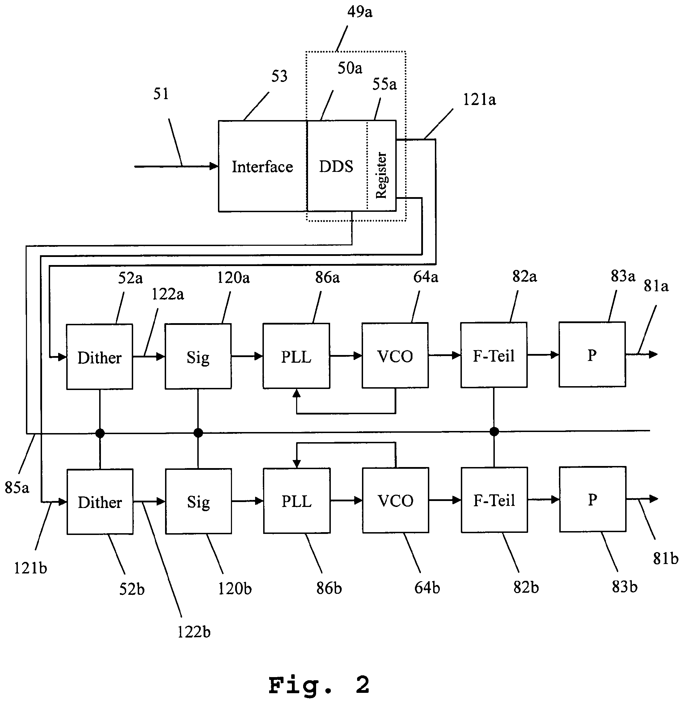

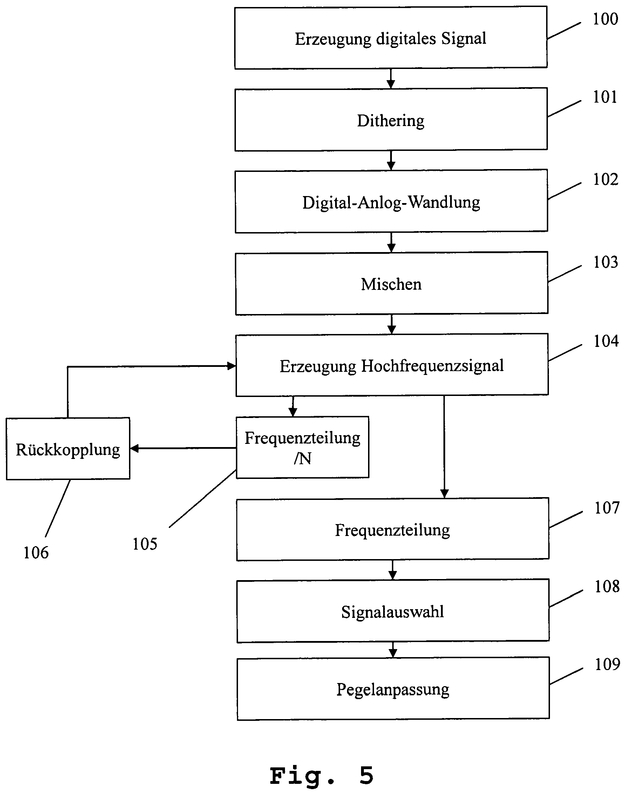

Zunächst wird anhand der Fig. 1 die der gegenwärtigen Erfindung zu Grunde liegende Problematik erläutert. Anhand der Fig. 2 - 4 wird anschließend der Aufbau und die Funktionsweise verschiedener Ausführungsbeispiele des erfindungsgemäßen Messgeräts gezeigt. Abschließend wird anhand von Fig. 5 die Funktionsweise eines Ausführungsbeispiels des erfindungsgemäßen Verfahrens dargestellt.

Identische Elemente wurden in ähnlichen Abbildungen zum Teil nicht wiederholt dargestellt und beschrieben.

Fig. 1 zeigt ein beispielhaftes Messgerät. Es handelt sich dabei um einen vektoriellen 2-Tor-Netzwerkanalysator.

Bei dem dargestellten Netzwerkanalysator ist an jedem Tor T1, T2 des Netzwerkanalysators eine separate Anregungs-/Empfangseinheit 2₁ bzw. 2₂ vorhanden. Jede Anregungs-/Empfangseinheit 2₁ bzw. 2₂ verfügt über einen Signalgenerator SO1 bzw. SO2, mit welchem das Messobjekt DUT mit einem Anregungssignal beaufschlagbar ist. Es kann entweder nur einer der beiden Signalgeneratoren SO1 bzw. SO2 aktiv sein oder es können auch beide Signalgeneratoren SO1 und SO2 jeweils ein Anregungssignal aussenden.

Das DUT verfügt über zumindest zwei Tore P1 und P2. Die beiden Tore P1 und P2 des Messobjekts DUT sind über eine Messleitung 3₁ bzw. 3₂ mit einem der beiden Tore T1 bzw. T2 des Netzwerkanalysators verbunden.

Die Signalgeneratoren SO1 und SO2 sind jeweils über ein variables Dämpfungsglied 3₁ bzw. 3₂ und jeweils einen Verstärker 4₁ bzw. 4₂ mit einem Signal-Verteiler (signal splitter) 5₁ bzw. 5₂ verbunden. Ein Signalzweig 6₁ bzw. 6₂ steht jeweils über eine Brücke (z.B. Richtkoppler) 7₁ bzw. 7₂ mit dem zugeordneten Tor T1 bzw. T2 in Verbindung. Der andere Zweig 8₁ bzw. 8₂ ist mit einem Mischer 10₁ bzw. 10₂ einer ersten Empfangseinrichtung 9₁ bzw. 9₂ der jeweiligen Anregungs-/Empfangseinheit 2₁ bzw. 2₂ verbunden. Die erste Empfangseinrichtung 9₁ bzw. 9₂ empfängt somit, wenn der zugehörige Signalgenerator SO1 bzw. SO2 aktiv ist, das Anregungssignal. Ferner wird dem Mischer 10₁ bzw. 10₂ ein Oszillatorsignal zugeführt, das von einem internen Oszillator LO1 bzw. LO2 der jeweiligen Anregungs-/Empfangseinheit 2₁ bzw. 2₂ erzeugt wird und dem Mischer 10₁ bzw. 10₂ über einen Signal-Verteiler (signal splitter) 11₁ und 11₂ und jeweils einen Verstärker 12₁ bzw. 12₂ zugeführt wird.

Der gleiche Oszillator LO1 bzw. LO2 versorgt über den anderen Signalzweig der Signal-Verteiler 11₁ bzw. 11₂ und einen entsprechenden Verstärker 13₁ bzw. 13₂ einen Mischer 14₁ bzw. 14₂ einer zweiten Empfangseinrichtung 15₁ bzw. 15₂ der jeweiligen Anregungs-/Empfangseinheit 2₁ bzw. 2₂. Der Mischer 14₁ bzw. 14₂ steht über einen Isolations-Verstärker 16₁ bzw. 16₂ und die Brücke 7₁ bzw. 7₂ mit dem zugeordneten Tor T1 bzw. T2 in Verbindung. Somit erhält die zweite Empfangseinrichtung 15₁ das von dem zugehörigen Tor T1 empfangene, von dem Messobjekt zum Tor T1 reflektierte oder durch das Messobjekt DUT von dem Tor T1 zum Tor T2 transmittierte Signal. Entsprechend empfängt die zweite Empfangseinrichtung 15₂ der Anregungs-/Empfangseinheit 2₂ das von dem Messobjekt DUT zum Tor T2 reflektierte oder durch das Messobjekt DUT vom Tor T1 zum Tor T2 transmittierte Signal. Die Mischer 10₁ und 14₁ der ersten Anregungs-/Empfangseinheit 2₁ setzen das empfangene Signal in eine erste Zwischenfrequenzlage mit der Zwischenfrequenz f_{IF1} um, während die Mischer 10₂ und 14₂ der zweiten Anregungs-/Empfangseinheit 2₂ das empfangene Signal in eine zweite Zwischenfrequenzlage mit der Zwischenfrequenz f_{IF2} umsetzen. Dabei sind die Zwischenfrequenzen f_{IF1} und f_{IF2} nicht notwendigerweise identisch.

Das von den Mischern 10₁ bzw. 10₂ erzeugte Zwischenfrequenz-Referenzsignal IF Ref 1 bzw. IF Ref 2 sowie das von den Mischern 14₁ bzw. 14₂ erzeugte Zwischenfrequenz-Messsignal IF Meas 1 bzw. IF Meas 2 wird einem Analog/Digital-Wandler 17 zugeführt, welcher mit einer Signalauswertungs- und Steuereinheit 18 in Verbindung steht. In dieser erfolgt eine Auswertung der Referenzsignale und der Messsignale. Die Signalauswertungs- und Steuereinheit 18 steuert ferner über Steuerleitungen 19, 20, 21 und 22 die Signalgeneratoren SO1 und SO2 sowie die Oszillatoren LO1 und LO2 so an, dass diese ein Signal mit vorbestimmter Frequenz f_{SO1}, f_{LO1}, f_{SO2} bzw. f_{LO2} und mit vorbestimmter Phase ϕ_{SO1}, ϕ_{LO1}, ϕ_{SO2} und ϕ_{LO2} erzeugen.

Über weitere Steuerleitungen 23 und 24 steht die Auswerte- und Steuereinheit 18 mit den einstellbaren Dämpfungsgliedern 3₁ und 3₂ in Verbindung, so dass die Signalamplitude des von den Signalgeneratoren SO1 und SO2 erzeugten Anregungssignals steuerbar ist. Da die Ist-Amplitude des Anregungssignals über die Zwischenfrequenz-Referenzsignale IF Ref 1 und IF Ref 2 erfasst werden, kann auf diese Weise eine Regelschleife zur exakten Regelung der Anregungsamplitude gebildet werden.

Die Steuerleitungen 19 bis 23 können zu einem Bus-System 25, insbesondere einem LAN-Bus-System, zusammengefasst werden. Durch unterschiedliche Einstellung der Phasen ϕ_{LO1}, ϕ_{LO2} bzw. ϕ_{SO1}, ϕ_{SO2} können Laufzeitunterschiede, beispielsweise in den Messleitungen 3₁ und 3₂ ausgeglichen werden.

Der dargestellte Netzwerkanalysator verfügt über eine Phasensynchronisationseinheit 30, die von weiteren Netzwerkanalysatoren die Signale CASC_READY, CASC_SYNC, CASC_REF und CASC_CLOCK empfängt bzw. an diese aussendet. In der Steuereinheit 18 wird festgelegt, ob der jeweilige Netzwerkanalysator übergeordnet (Master) oder untergeordnet (Slave) ist. Beispielsweise kann die Bedienperson an dem jeweiligen Netzwerkanalysator eingeben, dass dieser Netzwerkanalysator das übergeordnete Haupt-Gerät (Master) sein soll. Dieser Netzwerkanalysator sendet dann das Signal CASC an die übrigen Netzwerkanalysatoren, die daraufhin wissen, dass sie die untergeordneten Netzwerkanalysatoren (Slaves) bei der anstehenden Messaufgabe sind. Außerdem wird das Signal CASC an die Phasensynchronisationseinheit 30 gesandt.

Über eine Verbindungsleitung 31 steht die Phasensynchronisationseinheit 30 mit den Signalgeneratoren SO1 und SO2 sowie den lokalen Oszillatoren LO1 und LO2 in Verbindung und gibt diesen ein Haupt-Referenzsignal REF vor. Mit dem Analog/Digital-Wandler 17 steht die Phasensynchronisationseinheit 30 über eine Verbindungsleitung 32 in Verbindung und übermittelt an diese das Taktsignal AD_CLOCK zur Festlegung der Abtastzeit. Das zur Erzeugung des Haupt-Referenzsignals REF benötigte Hilfs-Referenzsignal REF_IN kann entweder extern zugeführt werden oder innerhalb des Netzwerkanalysators erzeugt werden.

Die Phasensynchronisations-Einheit 30 erzeugt dabei das Haupt-Referenzsignal REF. Ist das Messgerät der gegenwärtige Master, so wird es mittels eines zusätzlichen Hilfs-Referenzsignals REF_IN derart geregelt, dass es eine stabile Frequenz und Phase aufweist. Ist das Messgerät gegenwärtig ein Slave, so wird das Haupt-Referenzsignal REF einem von dem Master übertragenen Referenzsignal angeglichen.

Die Oszillatoren SO1, SO2, LO1, LO2 nutzen somit eine identische Referenz, um ihre Ausgangssignale zu erzeugen.

Würden die einzelnen Oszillatoren SO1, SO2, LO1, LO2 anschließend mittels fraktionalen Teilern Signale beliebiger Frequenzen erzeugen, ginge die Phasenbeziehung der Signale geht dabei jedoch verloren, da fraktionale Teiler keine zuverlässig nachvollziehbare Phase des Signals erzeugen. Die vorliegende Erfindung dient dazu, dieses Problem durch ein geeignetes Konzept der Frequenzaufbereitung zu lösen.

In Fig. 2 wird ein erstes Ausführungsbeispiel des erfindungsgemäßen Messgeräts dargestellt. Die Signalerzeugungseinheit des Messgeräts ist hier dargestellt. Eine Synthesizer-Einrichtung 49a beinhaltet einen direkten digitalen Synthesizer (direkten digitalen Signalerzeuger) 50a. Sie wird von einem Interface 53 gesteuert. Das Interface ist dabei mit einem Steuereingang 51 verbunden. Der direkte digitale Synthesizer 50a verfügt dabei über ein Register 55a, eine Addiereinrichtung und eine Phasentabelle. In dem Register 55a ist zu jedem Zeitpunkt eine Bit-Folge gespeichert. Das Register 55a bildet einen Phasenakkumulator. Bei jedem Takt wird durch die Addiereinrichtung zu dem Wert in dem Register 55a der an dem Steuereingang 51 anliegende Wert addiert. Der in dem Register 55a gespeicherte Wert wird jeweils von der Phasentabelle zu einem Ausgangswert des direkten digitalen Synthesizers verarbeitet. Dies geschieht durch Auslesen jeweils eines dem Registerwert entsprechenden Werts aus der Phasentabelle.

Die Signalerzeugung mit einem direkten digitalen Synthesizer (direct digital synthesis, DDS) basiert darauf, dass in dem Register 55a des Phasenakkumulators eine Vielzahl von Phasenwerten der zu erzeugenden Wellenform abgespeichert sind. Bei der zu erzeugenden Wellenform handelt es sich bevorzugt um eine Sinuswelle. Die entsprechenden Amplitudenwerte an einer Vielzahl unterschiedlicher Stellen der Periode der Sinusschwingung sind in dem Phasenakkumulator abgelegt. Durch Auslesen dieser Werte mit einer bestimmten Taktgeschwindigkeit kann eine digitale Folge von Amplitudenwerten erzeugt werden, die dem Signalverlauf entspricht. Je nach Taktrate bei der Auslesung entsteht nach dem Digital-Analog-Wandler eine unterschiedliche Frequenz der Wellenform. Durch Variation der Stelle, an welcher mit dem Auslesen der AmplitudenWerte aus dem Phasenakkumulator begonnen wird, lässt sich die Phasenlage der Wellenform verändern.

Das Register 55a verfügt dabei über eine hohe Breite von bevorzugt zumindest 30bit, besonders bevorzugt von 48bit. Dies resultiert in einer sehr hohen Frequenzauflösung der von dem direkten digitalen Synthesizer erzeugten Signale. Durch mehrere Anzapfungen des Phasenakkumulators können mehrere Signale identischer Frequenz, jedoch unterschiedlicher Phase, erzeugt werden. Die Phasen der Signale sind dabei durch Festlegung der Anzapfungen einstellbar. So können z.B. für Gegentakt-Messungen Signale exakt identischer Frequenz jedoch um 180° versetzter Phase erzeugt werden. Der direkte digitale Synthesizer 50a ist dabei mit einer Taktleitung 85a verbunden. Bei jedem Takt erzeugt der direkte digitale Synthesizer 50a einen digitalen Ausgangswert für jede Anzapfung. Die Taktfrequenz beträgt in diesem Ausführungsbeispiel 384MHz. In diesem Ausführungsbeispiel verfügt der direkte digitale Synthesizer 50a über 2 Anzapfungen. Es werden somit zwei Ausgangssignale auf die Leitungen 121a und 121b ausgegeben.

Die Signale werden an die Dithering-Einrichtungen 52a, 52b übertragen. Ein Dithering der Signale wird durchgeführt. Dies führt zu einer Fehlerstreuung und beseitigt Quantisierungsrauschen, welches durch die folgenden Digital-Analog-Wandler erzeugt wird. Weiterhin trägt diese Maßnahme zur Phasenrauschformung bei, was eine Verbesserung des trägernahen Phasenrauschens ermöglicht.

Als Dithering wird hier eine Überlagerung des hochgenauen Ausgangssignals des direkten digitalen Synthesizers mit einem hochfrequenten, weißen Rauschen geringer Amplitude verstanden. Auch die Dithering-Einrichtungen 52a, 52b sind mit der Takt-Leitung 85a verbunden.

Auf Grund der digitalen Verarbeitung sind die Frequenzen und Phasen der unterschiedlichen Signale genau bekannt. Der direkte digitale Synthesizer 50a, das Interface 53a und die Dithering-Einrichtungen 52a, 52b sind optional auf einem FPGA realisiert. Dies vereinfacht die Entwicklung und reduziert bei kleinen Stückzahlen die Herstellungskosten.

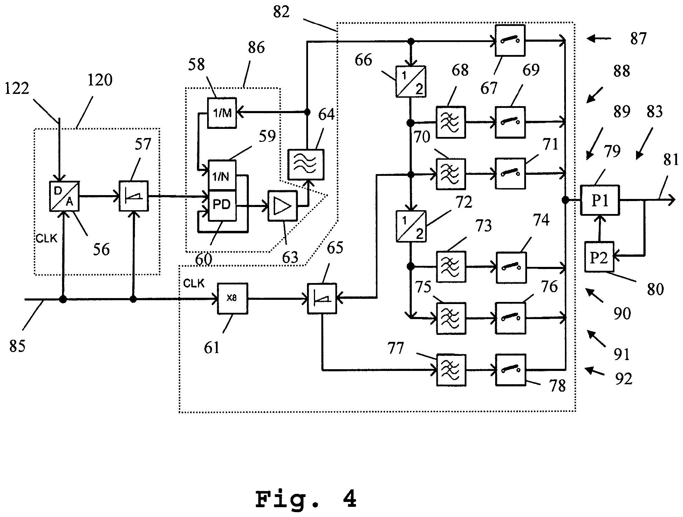

Von den Dithering-Einrichtungen 52a, 52b werden die Signale Signalaufbereitungs-Einrichtungen 120a, 120b zugeführt. Die Signalaufbereitungs-Einrichtungen 120a, 120b wandeln die digitalen Signale der Dithering-Einrichtungen 52a, 52b in analoge Signale und mischen die Signale mit dem Taktsignal, um sie in einen anderen Frequenzbereich zu transformieren. Auf die genaue Funktion der Signalaufbereitungs-Einrichtungen 120a, 120b wird anhand der Fig. 4 näher eingegangen.

Die Signalaufbereitungs-Einrichtungen 120a, 120b sind mit Regeleinrichtungen 86a, 86b verbunden. Die Regeleinrichtungen 86a, 86b sind mit gesteuerten Oszillatoren 64a, 64b verbunden. Die Ausgangssignale der Frequenzaufbereitungs-Einrichtungen 120a, 120b werden als Referenzsignale der Regeleinrichtungen 86a, 86b herangezogen. Die Reglereinrichtung 86a, 86b der Phase-Locked-Loop (Phasenrastende Schleife PLL) regelt die Ausgangssignale der gesteuerten Oszillatoren 64a, 64b sehr genau in ihrer Frequenz und Phase. Die Ausgangssignale der gesteuerten Oszillatoren 64a, 64b stehen dabei in einem festen Frequenzverhältnis und in einem festen Phasenverhältnis zu den jeweiligen Ausgangssignalen der Frequenzaufbereitungs-Einrichtungen 120a, 120b. Die Funktion der Regeleinrichtungen 86a, 86b, insbesondere die Frequenzerhöhung von ihrem Eingangssignal zu dem Ausgangssignal der gesteuerten Oszillatoren 64a, 64b wird dabei optional von dem Interface 53 gesteuert.

Die gesteuerten Oszillatoren 64a, 64b weisen dabei einen Frequenzbereich von 6-12GHz auf. Um auch Frequenzen unterhalb dieses Bereichs zu erzeugen, werden ihre Ausgangssignale Frequenzteilungseinrichtungen 82a, 82b zugeführt. Die Frequenzteilungseinrichtungen 82a, 82b teilen die Frequenzen der Eingangssignale und erzeugen so Signale mit beliebigen Frequenzen von 0-12GHz. Hierauf wird anhand von Fig. 4 näher eingegangen. Auch die Frequenzteilungseinrichtungen 82a, 82b werden mit dem Taktsignal versorgt.

Die weitergeleiteten Signale werden Pegelanpassungs-Einrichtungen 83a, 83b in ihren Pegeln angepasst und über die Ausgänge 81a, 81b ausgegeben. Auch hierauf wird anhand von Fig. 4 näher eingegangen.

Damit die starren Phasenverhältnisse der direkten digitalen Synthesizer im Ausgangssignal der Signalgeneratoren nicht verloren gehen, sind während der gesamten Signalverarbeitung keinerlei Komponenten eingesetzt, welche einen unvorhersehbaren Phasensprung hervorrufen können. So sind keine umschaltbaren Oszillatoren oder nichtganzzahlige Teiler vorhanden.

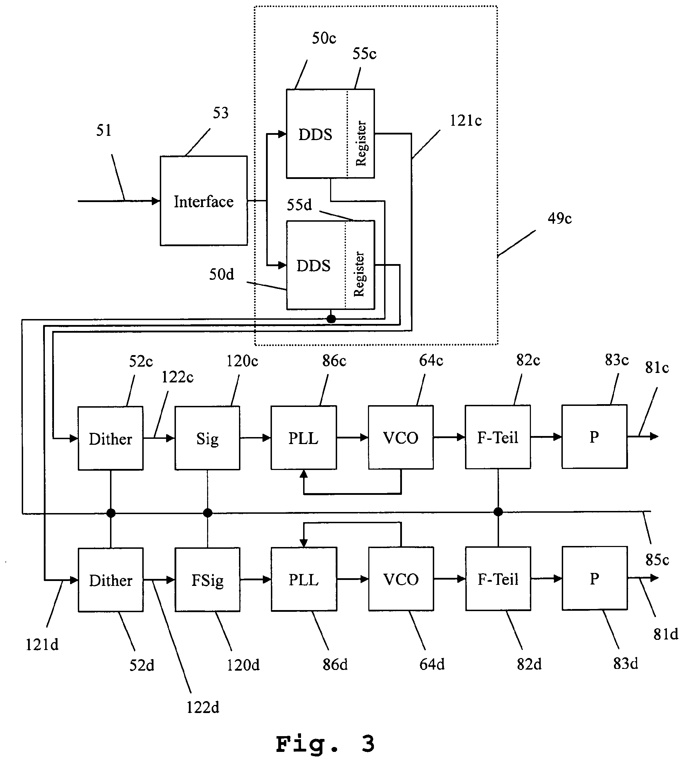

In Fig. 3 wird ein zweites Ausführungsbeispiel des erfindungsgemäßen Messgeräts dargestellt. Das zweite Ausführungsbeispiel entspricht dabei zu großen Teilen dem ersten Ausführungsbeispiel. Die Synthesizer-Einrichtung 49c beinhaltet hier jedoch zwei getrennte direkte digitale Synthesizer 50c, 50d mit getrennten Registern 55c, 55d. Diese werden von derselben Taktleitung 85c mit einem Taktsignal versorgt und arbeiten damit synchron. Eine Einstellung unabhängiger Frequenzen und Phasen ist so jedoch möglich. So können z.B. für komplexe frequenzumsetzende Messungen Signale unterschiedlicher Frequenzen und Phasen jedoch mit bekanntem Phasenverhältnis erzeugt werden.

Im Weiteren entspricht der Aufbau der Fig. 3 dem Aufbau aus Fig. 2. Die Leitungen 121c, 121d entsprechen den Leitungen 121a, 121b. Die Dither-Einrichtungen 52c, 52d entsprechen den Dither-Einrichtungen 52a, 52b. Die Leitungen 122c, 122d entsprechen den Leitungen 122a, 122b. Die Signalaufbereitungs-Einrichtungen 120c, 120d entsprechen den Signalaufbereitungs-Einrichtungen 120a, 120b. Die Regeleinrichtungen 86c, 86d entsprechen den Regeleinrichtungen 86a, 86b. Die gesteuerten Oszillatoren 64c, 64d entsprechen den gesteuerten Oszillatoren 64a, 64b. Die Frequenzteilungseinrichtungen 82c, 82d entsprechen den Frequenzteilungseinrichtungen 82a, 82b. Die Pegelanpassungs-Einrichtungen 83c, 83d entsprechen den Pegelanpassungs-Einrichtungen 83a, 83b.

Fig. 4 zeigt eine Detailansicht des ersten und zweiten Ausführungsbeispiels des erfindungsgemäßen Messgeräts. Dargestellt ist ein Signalverarbeitungszweig, welcher einem einzelnen Signalausgang eines direkten digitalen Synthesizers 50a, 50c, 50d nachgeschaltet ist. Dieser Aufbau ist identisch bei sämtlichen Leitungen 122a, 122b, 122c, 122d der Fig. 2 und Fig. 3. Das digitale Ausgangssignal der Dithering-Einrichtung wird dem Digital-Analog-Wandler 56 zugeführt. Das analoge Ausgangssignal des Digital-Analog-Wandlers 56 wird dem Mischer 57 zugeführt. Dieser mischt es mit dem Taktsignal, welches ihm über die Taktleitung 85 zugeführt wird. Es kann eine Heraufmischung oder eine Heruntermischung eingesetzt werden. In diesem Ausführungsbeispiel wird eine Heraufmischung eingesetzt. D.h. das resultierende Signal weist eine Frequenz auf, welche der Summe der Frequenz des Taktsignals und der Frequenz des Signals des jeweiligen direkten digitalen Synthesizers entspricht. Bei einer beispielhaften Taktfrequenz von 384MHz und einer beispielhaften möglichen Frequenz des Signals des direkten digitalen Synthesizers von 40MHz-100MHz ergibt sich eine Signalfrequenz von 424-484MHz nach dem Mischer 57.

Das Ausgangssignal des Mischers 57 wird der Regeleinrichtung 86 zugeführt. Die Regeleinrichtung 86 beinhalt dabei zumindest einen ganzzahligen Frequenzteiler 58, 59. In diesem Ausführungsbeispiel werden zwei nacheinander geschaltete ganzzahlige Frequenzteiler 58, 59 eingesetzt. Weiterhin beinhaltet die Regeleinrichtung 86 einen Phasendiskriminator 60 und einen Schleifenregler 63. Das analoge Signal, welches von dem Mischer 57 erzeugt wurde, wird dem Phasendiskriminator 60 zugeführt. Dieser vergleicht die Phase des analogen Signals und eines zurückgekoppelten Signals. Der Phasendiskriminator 60 gibt als Ausgangssignal ein digitales Signal aus, welches eine vorlaufende oder nachlaufende Phase anzeigt. Der Schleifenregler 63 führt eine Tiefpassfilterung und Umsetzung des digitalen Signals des Phasendiskriminators 60 durch und steuert den spannungsgesteuerten Oszillator 64 mit einem geeigneten Regelsignal an.

Der spannungsgesteuerte Oszillator 64 erzeugt ein hochfrequentes Signal. Die Frequenz des hochfrequenten Signals wird von den ganzzahligen Teilern 58, 59 geteilt und an den Phasendiskriminator 60 als Regelgröße zurückgekoppelt. Über die Frequenz des von dem direkten digitalen Synthesizers ausgegebenen Signals und den Teilungsfaktoren des Teiler 58, 59 kann somit die genaue Frequenz des von dem spannungsgesteuerten Oszillator 64 erzeugten Signals eingestellt werden. Auf Grund einer eingeschränkten Bandbreite des Oszillators 64 sind lediglich Ausgangssignale innerhalb einer bestimmten Bandbreite möglich. Der in diesem Ausführungsbeispiel eingesetzte Oszillator 64 verfügt über eine Bandbreite von 6-12GHz.

Die Frequenzteilungseinrichtung 82 beinhaltet mehrere Signalpfade bzw. Frequenzpfade 87 - 92. Die Signalpfade 87 - 92 dienen dabei der Verarbeitung von Signalen unterschiedlicher Frequenzen. Jeder Signalpfad 87 - 92 beinhaltet einen Schalter 67, 69, 71, 74, 76, 78. Die Schalter 67, 69, 71, 74, 76, 78 aktivieren die Signalpfade 87 - 92, indem sie ihr Ausgangssignal durchleiten. Es ist stets nur genau ein Signalpfad 87 - 92 aktiv, d.h. genau ein Schalter 67, 69, 71, 74, 76, 78 geschlossen.

Der erste Signalpfad 87 beinhaltet lediglich den Schalter 67. Dieser Signalpfad 87 verarbeitet somit lediglich den unmodifizierten Frequenzbereich des spannungsgesteuerten Oszillators 64 von in diesem Ausführungsbeispiel 6GHz bis 12GHz. Der zweite Signalpfad 88 beinhaltet einen Frequenzteiler 66, welcher die Frequenzen anliegender Signale halbiert, einen Tiefpassfilter 68 und den Schalter 69. Der Frequenzteiler 66 ist ein Frequenzhalbierer und halbiert die Frequenz des spannungsgesteuerten Oszillators 64. Neben einer Halbierung der Frequenz durch den Frequenzteiler 66 sind jedoch auch beliebige andere Teilungsfaktoren denkbar.

Das Tiefpassfilter 68 filtert hochfrequente Anteile oberhalb von 6GHz. Der zweite Signalpfad könnte somit Frequenzen von 3GHz bis 6GHz verarbeiten. Um einfachere Filter einsetzen zu können, wird dieser Bereich jedoch durch Einsatz eines dritten Signalpfads 89 geteilt. D.h. der zweite Signalpfad 88 verarbeitet Signale von 4,5GHz bis 6GHz. Der dritte Signalpfad verarbeitet Signale von 3GHz bis 4,5 GHz. Der dritte Signalpfad 89 ist analog dem zweiten Signalpfad 88 aufgebaut. Das Filter 70 entspricht dem Filter 68. Der Schalter 71 entspricht dem Schalter 69.

Um noch tiefere Frequenzen verarbeiten zu können werden weitere zwei analog aufgebaute Signalpfade 90, 91 eingesetzt. Diesen ist ein weiterer Frequenzteiler 72 vorgeschaltet, welcher die Frequenzen eingehender Signale halbiert. D.h. am Ausgang dieses Frequenzteilers 72 liegen somit Signale mit ¼ der Frequenz der Signale des spannungsgesteuerten Oszillators 64 vor. Der vierte Signalpfad 90 beinhaltet den Tiefpassfilter 73 und den Schalter 74. Er verarbeitet Signale von 2GHz bis 3GHz. Der fünfte Signalpfad 91 beinhaltet den Tiefpassfilter 75 und den Schalter 76. Er verarbeitet Signale von 1,5GHz bis 2GHz.

Eine Verarbeitung von Signalen noch niedrigerer Frequenz würde den Einsatz weiterer Frequenzteiler erfordern. Dies würde jedoch das Komponentenrauschen erhöhen und höhere Kosten verursachen. Außerdem kann mittels einer Frequenzteilung eine Frequenz von 0Hz nicht erreicht werden. Deshalb wird ein einzelner zusätzlicher Frequenzpfad für den Bereich von 0GHz bis 1,5GHz eingeführt. Dieser Signalpfad 92 arbeitet nicht analog den übrigen Signalpfaden 87 - 91. Stattdessen wird von einem Frequenzvervielfacher 61 die Frequenz des Taktsignals vervielfacht. In diesem Ausführungsbeispiel beträgt der Multiplikationsfaktor 8. Das resultierende Signal weist bei einer Taktfrequenz von 384MHz eine Frequenz von 3,072GHz auf. Dieses Signal wird mit dem in seiner Frequenz um den Teilungsfaktor reduzierten Signal des spannungsgesteuerten Oszillators 64 aus dem zweiten Signalpfad 88 in einem Mischer 65 heruntergemischt. Das resultierende Signal weist in diesem Beispiel einen Frequenzbereich von 0GHz bis 3GHz auf. Zur Erhöhung der spektralen Reinheit wird ein Tiefpassfilter 77 eingesetzt, welches hochfrequente Anteile über 1,5GHz filtert. Von dem Schalter 78 wird das resultierende Signal bei Bedarf durchgeschaltet.

Alternativ könnte ein weiterer Signalpfad durch direkte Nutzung des in ein analoges Signal gewandelten Signals des direkten digitalen Synthesizers eingefügt werden. So könnten sehr geringe Frequenzen mit sehr hoher Genauigkeit erzeugt werden.

Die Signalpfade 87 - 92 arbeiten parallel. D.h. lediglich die Stellung der Schalter 67, 69, 71, 74, 76, 78 entscheidet darüber, welches Signal weitergeleitet wird.

Der Pegel des Signals wird von einer Pegelveränderungseinrichtung 79 ausgeglichen. Am Ausgang der Pegelveränderungseinrichtung 79 wird der Pegel des Signals von einer Pegelbestimmungseinrichtung 80 bestimmt und dieser an die Pegelveränderungseinrichtung 79 gegeben. Es findet eine Rückkopplung statt, welche eine Regelung des Pegels bewirkt. Der Pegel wird um bis zu +/-5dB modifiziert. Größere Änderungen des Pegels sind nicht notwendig, da die Signalpfade bereits einen weitgehend konstanten Pegelverlauf über der Frequenz aufweisen. Das in seinem Pegel angepasste Signal wird über den Signalausgang 81 ausgegebnen.

Fig. 5 zeigt ein Ausführungsbeispiel des erfindungsgemäßen Verfahrens zum Betrieb des Messgeräts. In einem ersten Schritt 100 werden zumindest zwei digitale Hochfrequenzsignale erzeugt. Die Erzeugung erfolgt dabei Frequenz- und Phasengenau mit einer sehr hohen Genauigkeit von z.B. 48bit. In diesem Ausführungsbeispiel beträgt die Frequenz des erzeugten Signals zwischen 40MHz und 100MHz. Die Erzeugung der Signale erfolgt dabei mittels direkter digitaler Synthese. In einem zweiten Schritt 101 wird ein Dithering durchgeführt. D.h. die digitalen Signale werden mit hochfrequentem weißen Rauschen geringer Amplitude beaufschlagt.

In einem dritten Schritt 102 werden die Signale in analoge Signale umgewandelt. Dies erfolgt mit einer deutlich geringeren Genauigkeit, z.B. 12bit, als die Erzeugung des Signals. Auf Grund des Ditherings ergeben sich jedoch im Durchschnitt die korrekte Frequenz und korrekte Phasenlage der Signale.

In einem vierten Schritt 103 werden die analogen Signale mit einem Taktsignal gemischt. Hierdurch werden sie in einen anderen Frequenzbereich transformiert. In diesem Ausführungsbeispiel beträgt die Taktfrequenz 384MHz und es wird eine Heraufmischung durchgeführt. Dies führt zu einem Frequenzbereich der resultierenden Signale von 424-484MHz.

In einem fünften Schritt 104 werden aus den analogen Signalen Signale wesentlich höherer Frequenz erzeugt. Hierzu werden die Signale einem Phasendiskriminator einer PLL (Phase Locked Loop) zugeführt. In diesem Ausführungsbeispiel liegt die Ausgangs-Frequenz der PLL zwischen 6GHz und 12GHz. In einem sechsten Schritt 105 werden die resultierenden sehr hochfrequenten Signale durch einen ganzzahligen Teilungsfaktor geteilt. Dies kann in einem Schritt oder in mehreren Schritten erfolgen. In einem siebten Schritt 106 werden die geteilten Signale zurückgekoppelt und dienen als Regelgröße für die PLL. So kann ein Signal sehr stabiler Frequenz und Phase erzielt werden.

Der fünfte, sechste und siebte Schritt 104, 105, 106 werden ständig wiederholt. Eine dauerhafte Regelung der Frequenz der resultierenden Signale wird so erreicht. In einem achten Schritt 107 wird eine Frequenzteilung durchgeführt. Dabei werden die Frequenzen der Signale in zumindest einem Schritt geteilt. Eine Teilung in mehreren Schritten ist ebenfalls möglich. Die Signale werden dadurch in mehrere Signalpfade unterschiedlicher Frequenzbereiche aufgespalten.

In einem neunten Schritt 108 wird jeweils eines der mehreren Signale ausgewählt. Lediglich dieses jeweils eine Signal wird zur Weiterverarbeitung geleitet. Die Signale der übrigen Frequenzpfade 87 - 92 werden nicht weitergeleitet. In einem zehnten Schritt 109 werden die ausgewählten Signale einer Pegelanpassung unterzogen.

Somit ist sichergestellt, dass der Pegel des Ausgangssignals unabhängig von seiner Frequenz ist.

Die Erfindung ist nicht auf das dargestellte Ausführungsbeispiel beschränkt. Wie bereits erwähnt, kann eine größere Anzahl von Signalen ausgehend von mehreren direkten digitalen Synthesizern erzeugt werden. Auch der Einsatz einer abweichenden Regelung der Hochfrequenz ist denkbar. Darüber hinaus sind alternative Ausgestaltungen der Frequenzpfade der Frequenzteilungseinrichtung möglich. Alle vorstehend beschriebenen Merkmale oder in den Figuren gezeigten Merkmale sind im Rahmen der Erfindung beliebig vorteilhaft miteinander kombinierbar.

## Patentansprüche

1. Messgerät mit einer Synthesizer-Einrichtung (49a, 49c), zumindest zwei Regeleinrichtungen (86, 86a, 86b, 86c, 86d) und zumindest zwei gesteuerten Oszillatoren (64, 64a, 64b, 64c, 64d),
wobei die Synthesizer-Einrichtung (49a, 49c) zumindest einen direkten digitalen Synthesizer (50a, 50c, 50d) beinhaltet, der dafür konfiguriert ist, Referenzsignale für zumindest eine der Regeleinrichtungen (86, 86a, 86b, 86c, 86d) zu bilden,
wobei die Regeleinrichtungen (86, 86a, 86b, 86c, 86d) dafür konfiguriert sind, die gesteuerten Oszillatoren (64, 64a, 64b, 64c, 64d) direkt oder indirekt zu steuern, wobei das Messgerät Frequenzteiler (58, 59, 66, 72), die dafür konfiguriert sind, durch einen ganzzahligen Teilungsfaktor (M, N, 2) zu teilen, beinhaltet, und wobei das Messgerät keine fraktionalen Frequenzteiler beinhaltet,
**dadurch gekennzeichnet,**
**dass** der zumindest eine direkte digitale Synthesizer konfiguriert ist, zumindest zwei Signale identischer Frequenz, unterschiedlicher Phase und bekannten Phasenverhältnisses zu erzeugen, wobei die Phasen der Signale einstellbar sind, dass die Regeleinrichtungen (86, 86a, 86b, 86c, 86d) jeweils einen Phasendiskriminator (60), einen Schleifenregler (63) und zumindest einen Frequenzteiler (58, 59), der dafür konfiguriert ist, um ganzzahlige Teilerfaktoren (M,N) zu teilen, beinhalten, und dass der Frequenzteiler (58, 59) konfiguriert ist, die Frequenz jeweils eines von einem der gesteuerten Oszillatoren (64, 64a, 64b, 64c, 64d) erzeugten Signals zu teilen, und das von ihm erzeugte Signal an den Phasendiskriminator (60) zu übertragen.

2. Messgerät nach Anspruch 1,
**dadurch gekennzeichnet,**
**dass** das Messgerät zumindest zwei Frequenzteilungseinrichtungen (82, 82a, 82b, 82c, 82d) beinhaltet, und
**dass** jede Frequenzteilungseinrichtung (82, 82a, 82b, 82c, 82d) von einem der gesteuerten Oszillatoren (64, 64a, 64b, 64c, 64d) erzeugte Signale verarbeitet.

3. Messgerät nach Anspruch 2,
**dadurch gekennzeichnet,**
**dass** jede Frequenzteilungseinrichtung (82, 82a, 82b, 82c, 82d) mehrere Frequenzpfade (87, 88, 89, 90, 91, 92) für Signale unterschiedlicher Frequenzbereiche beinhaltet, dass jeder Frequenzpfad (87, 88, 89, 90, 91, 92) eine Schalteinrichtung (67, 69, 71, 74, 76, 78) beinhaltet, welche den Frequenzpfad (87, 88, 89, 90, 91, 92) auf einen Signalausgang schaltet, und
**dass** gleichzeitig genau ein Frequenzpfad (87, 88, 89, 90, 91, 92) mittels der Schalteinrichtung (67, 69, 71, 74, 76, 78) auf den Signalausgang geschaltet ist.

4. Messgerät nach Anspruch 3,
**dadurch gekennzeichnet,**
**dass** zumindest ein Frequenzpfad (88, 89, 90, 91, 92) ein Filter (68, 70, 73, 75, 77) beinhaltet, und dass zumindest ein Frequenzpfad (88, 89, 90, 91, 92) zumindest einen Frequenzteiler (66, 72) beinhaltet, welcher um ganzzahlige Teilerfaktoren teilt.

5. Messgerät nach Anspruch 3 oder 4,
**dadurch gekennzeichnet,**
**dass** ein Mischer (65) innerhalb zumindest eines Frequenzpfades (92) angeordnet ist,
**dass** der Mischer (65) innerhalb des Frequenzpfades (92) das Signal des Frequenzpfads (92) mit einer Taktfrequenz oder einem Vielfachen einer Taktfrequenz heruntermischt.

6. Messgerät nach einem der Ansprüche 1 bis 5,
**dadurch gekennzeichnet,**
**dass** zwischen der Synthesizer-Einrichtung (49a, 49c) und den gesteuerten Oszillatoren (64, 64a, 64b, 64c, 64d) zumindest ein Mischer (57) angeordnet ist, und
**dass** der Mischer (57) zumindest ein von der Synthesizer-Einrichtung (49a, 49c) erzeugtes Signal mit einem Taktsignal oder einem Vielfachen eines Taktsignals mischt.

7. Messgerät nach einem der Ansprüche 1 bis 6,
**dadurch gekennzeichnet,**
**dass** die Synthesizer-Einrichtung (49a, 49c) digitale Signale mit hoher Genauigkeit erzeugt,
**dass** zwischen der Synthesizer-Einrichtung (49a, 49c) und den gesteuerten Oszillatoren (64, 64a, 64b, 64c, 64d) zumindest ein Digital-Analog-Wandler (56) angeordnet ist, dass der Digital-Analog-Wandler (56) ein von der Synthesizer-Einrichtung (49a, 49c) erzeugtes Signal in ein analoges Signal umwandelt,
**dass** der Digital-Analog-Wandler (56) über eine geringere Quantisierungs-Genauigkeit verfügt als die Synthesizer-Einrichtung (49a, 49c),
**dass** der Synthesizer-Einrichtung (49a, 49c) zumindest eine Dithering-Einrichtung (52a, 52b, 52c, 52d) nachgeschaltet ist, und
**dass** die Dithering-Einrichtung (52a, 52b, 52c, 52d) ein Dithering zumindest eines von der Synthesizer-Einrichtung (49a, 49c) erzeugten Signals durchführt.

8. Verfahren umfassend den Betrieb eines Messgeräts nach Anspruch.

9. Verfahren nach Anspruch 8,
**dadurch gekennzeichnet,**
**dass** von den gesteuerten Oszillatoren (64, 64a, 64b, 64c, 64d) erzeugte Signale von Frequenzteilungseinrichtungen (82, 82a, 82b, 82c, 82d) verarbeitet werden.

10. Verfahren nach Anspruch 9,
**dadurch gekennzeichnet,**
**dass** jede Frequenzteilungseinrichtung (82, 82a, 82b, 82c, 82d) mehrere Frequenzpfade (87, 88, 89, 90, 91, 92) für Signale unterschiedlicher Frequenzbereiche beinhaltet, dass jeder Frequenzpfad (87, 88, 89, 90, 91, 92) eine Schalteinrichtung (67, 69, 71, 74, 76, 78) beinhaltet, und dass durch die Schalteinrichtung (67, 69, 71, 74, 76, 78) genau ein Frequenzpfad auf einen gemeinsamen Signalausgang (81) geschaltet wird.

11. Verfahren nach Anspruch 10,
**dadurch gekennzeichnet,**
**dass** die Signale auf zumindest einem Frequenzpfad (88, 89, 90, 91, 92) gefiltert werden, und
**dass** die Frequenzen der Signale auf zumindest einem Frequenzpfad (88, 89, 90, 91, 92) durch einen ganzzahligen Teilerfaktor geteilt werden.

12. Verfahren nach Anspruch 10 oder 11,
**dadurch gekennzeichnet,**
**dass** die Signale zumindest eines Frequenzpfades (92) mit einer Taktfrequenz oder einem Vielfachen einer Taktfrequenz heruntergemischt werden.

13. Verfahren nach einem der Ansprüche 8 bis 12,
**dadurch gekennzeichnet,**
**dass** die von der Synthesizer-Einrichtung (49a, 49c) erzeugten Signale mit einem Taktsignal oder einem Vielfachen eines Taktsignals gemischt werden.

14. Verfahren nach einem der Ansprüche 8 bis 13,
**dadurch gekennzeichnet,**
**dass** von der Synthesizer-Einrichtung (49a, 49c) digitale Signale mit hoher Genauigkeit erzeugt werden,
**dass** die von der Synthesizer-Einrichtung (49a, 49c) erzeugten Signale einer Digital-Analog-Wandlung unterzogen werden,
**dass** die Digital-Analog-Wandlung über eine geringere Genauigkeit verfügt als die Erzeugung der Signale durch die Synthesizer-Einrichtung (49a, 49c), und
**dass** die von der Synthesizer-Einrichtung (49a, 49c) erzeugten Signale einem Dithering unterzogen werden.

## Claims

1. Measuring device with a synthesizer unit (49a, 49c), at least two control units (86, 86a, 86b, 86c, 86d) and at least two controlled oscillators (64, 64a, 64b, 64c, 64d),
wherein the synthesizer unit (49a, 49c) comprises at least one direct digital synthesizer (50a, 50c, 50d) which is configured to form reference signals for at least one of the control units (86, 86a, 86b, 86c, 86d), wherein the control units (86, 86a, 86b, 86c, 86d) are configured to control the controlled oscillators (64, 64a, 64b, 64c, 64d) directly or indirectly,
wherein the measuring device comprises frequency dividers (58, 59, 66, 72) which are configured to divide by an integer dividing factor (M, N, 2), and
wherein the measuring device comprises no fractional frequency dividers,
**characterised in that**
the at least one direct digital synthesizer is configured to generate at least two signals of identical frequency, of different phase and of known phase ratio,
wherein the phases of the signals are adjustable,
**in that** the control units (86, 86a, 86b, 86c, 86d) each comprise a phase discriminator (60), a loop controller (63) and at least one frequency divider (58, 59) which is configured to divide by integer divider factors (M, N), and
**in that** the frequency divider (58, 59) is configured to divide the frequency of in each case one signal generated by one of the controlled oscillators (64, 64a, 64b, 64c, 64d), and to transmit the signal generated by it to the phase discriminator (60).

2. Measuring device according to claim 1,
**characterised in that**
the measuring device comprises at least two frequency dividing units (82, 82a, 82b, 82c, 82d), and
**in that** each frequency dividing unit (82, 82a, 82b, 82c, 82d) processes signals generated by one of the controlled oscillators (64, 64a, 64b, 64c, 64d).

3. Measuring device according to claim 2,
**characterised in that**
each frequency dividing unit (82, 82a, 82b, 82c, 82d) comprises a plurality of frequency paths (87, 88, 89, 90, 91, 92) for signals of different frequency ranges,
**in that** each frequency path (87, 88, 89, 90, 91, 92) comprises a switching unit (67, 69, 71, 74, 76, 78) which switches the frequency path (87, 88, 89, 90, 91, 92) to a signal output, and
**in that** at the same time just one frequency path (87, 88, 89, 90, 91, 92) is switched to the signal output by means of the switching unit (67, 69, 71, 74, 76, 78).

4. Measuring device according to claim 3,
**characterised in that**
at least one frequency path (88, 89, 90, 91, 92) comprises a filter (68, 70, 73, 75, 77), and **in that** at least one frequency path (88, 89, 90, 91, 92) comprises at least one frequency divider (66, 72) which divides by integer divider factors.

5. Measuring device according to claim 3 or 4,
**characterised in that**
a mixer (65) is arranged inside at least one frequency path (92),
**in that** the mixer (65) inside the frequency path (92) mixes the signal of the frequency path (92) down with a clock frequency or a multiple of a clock frequency.

6. Measuring device according to one of claims 1 to 5,
**characterised in that**
at least one mixer (57) is arranged between the synthesizer unit (49a, 49c) and the controlled oscillators (64, 64a, 64b, 64c, 64d), and
**in that** the mixer (57) mixes at least one signal generated by the synthesizer unit (49a, 49c) with a clock signal or a multiple of a clock signal.

7. Measuring device according to one of claims 1 to 6,
**characterised in that**
the synthesizer unit (49a, 49c) generates digital signals with high accuracy,
**in that** at least one digital-to-analog converter (56) is arranged between the synthesizer unit (49a, 49c) and the controlled oscillators (64, 64a, 64b, 64c, 64d),
**in that** the digital-to-analog converter (56) converts a signal generated by the synthesizer unit (49a, 49c) into an analog signal,
**in that** the digital-to-analog converter (56) has a lower quantization accuracy than the synthesizer unit (49a, 49c),
**in that** the synthesizer unit (49a, 49c) is followed by at least one dithering unit (52a, 52b, 52c, 52d), and
**in that** the dithering unit (52a, 52b, 52c, 52d) carries out dithering of at least one signal generated by the synthesizer unit (49a, 49b).

8. Method comprising the operation of a measuring device according to claim 1.

9. Method according to claim 8,
**characterised in that**
signals generated by the controlled oscillators (64, 64a, 64b, 64c, 64d) are processed by frequency dividing units (82, 82a, 82b, 82c, 82d).

10. Method according to claim 9,
**characterised in that**
each frequency dividing unit (82, 82a, 82b, 82c, 82d) comprises a plurality of frequency paths (87, 88, 89, 90, 91, 92) for signals of different frequency ranges,
**in that** each frequency path (87, 88, 89, 90, 91, 92) comprises a switching unit (67, 69, 71, 74, 76, 78), and **in that** just one frequency path is switched to a common signal output (81) by the switching unit (67, 69, 71, 74, 76, 78).

11. Method according to claim 10,
**characterised in that**
the signals on at least one frequency path (88, 89, 90, 91, 92) are filtered, and
**in that** the frequencies of the signals on at least one frequency path (88, 89, 90, 91, 92) are divided by an integer divider factor.

12. Method according to claim 10 or 11,
**characterised in that**
the signals of at least one frequency path (92) are mixed down with a clock frequency or a multiple of a clock frequency.

13. Method according to one of claims 8 to 12,
**characterised in that**
the signals generated by the synthesizer unit (49a, 94c) are mixed with a clock signal or a multiple of a clock signal.

14. Method according to one of claims 8 to 13,
**characterised in that**
digital signals of high accuracy are generated by the synthesizer unit (49a, 49c),
**in that** the signals generated by the synthesizer unit (49a, 49c) are subjected to digital-to-analog conversion, **in that** the digital-to-analog conversion is of lower accuracy than the generation of the signals by the synthesizer unit (49a, 49c), and
**in that** the signals generated by the synthesizer unit (49a, 49c) are subjected to dithering.

## Revendications

1. Appareil de mesure comprenant un dispositif à synthétiseur (49a, 49c), au moins deux dispositifs de réglage (86, 86a, 86b, 86c, 86d) et au moins deux oscillateurs commandés (64, 64a, 64b, 64c, 64d),
dans lequel le dispositif à synthétiseur (49a, 49c) comporte au moins un synthétiseur numérique direct (50a, 50c, 50d), qui est configuré pour former des signaux de référence pour au moins un des dispositifs de réglage (86, 86a, 86b, 86c, 86d),
dans lequel les dispositifs de réglage (86, 86a, 86b, 86c, 86d) sont configurés pour commander directement ou indirectement les oscillateurs commandés (64, 64a, 64b, 64c, 64d),
dans lequel l'appareil de mesure comporte des diviseurs de fréquence (58, 59, 66, 72) qui sont configurés pour assurer une division par un facteur de division entier (M, N, 2), et
dans lequel l'appareil de mesure ne comporte aucun diviseur de fréquence fractionnel,
**caractérisé**
**en ce que** ledit au moins un synthétiseur numérique direct est configuré pour générer au moins deux signaux de fréquence identique, de phase différente et à la relation de phase connue, les phases des signaux étant réglables,
**en ce que** les dispositifs de réglage (86, 86a, 86b, 86c, 86d) comportent chacun un discriminateur de phase (60), un régulateur de boucle (63) et au moins un diviseur de fréquence (58, 59), qui est configuré pour assurer une division par des facteurs de division entiers (M, N),
et **en ce que** le diviseur de fréquence (58, 59) est configuré pour diviser la fréquence respectivement d'un signal généré par un des oscillateurs commandés (64, 64a, 64b, 64c, 64d) et pour transmettre le signal généré par ledit oscillateur au discriminateur de phase (60).

2. Appareil de mesure selon la revendication 1,
**caractérisé**
**en ce que** l'appareil de mesure comporte au moins deux dispositifs de division de fréquence (82, 82a, 82b, 82c, 82d), et
**en ce que** chaque dispositif de division de fréquence (82, 82a, 82b, 82c, 82d) traite les signaux générés par un des oscillateurs commandés (64, 64a, 64b, 64c, 64d).

3. Appareil de mesure selon la revendication 2,
**caractérisé**
**en ce que** chaque dispositif de division de fréquence (82, 82a, 82b, 82c, 82d) comporte plusieurs trajets de fréquence (87, 88, 89, 90, 91, 92) pour des signaux de différentes plages de fréquences,
**en ce que** chaque trajet de fréquence (87, 88, 89, 90, 91, 92) comporte un dispositif de commutation (67, 69, 71, 74, 76, 78), lequel commute le trajet de fréquence (87, 88, 89, 90, 91, 92) sur une sortie de signal, et
**en ce que** dans le même temps, un seul trajet de fréquence (87, 88, 89, 90, 91, 92) est commuté sur la sortie de signal au moyen du dispositif de commutation (67, 69, 71, 74, 76, 78).

4. Appareil de mesure selon la revendication 3,
**caractérisé**
**en ce qu'**au moins un trajet de fréquence (88, 89, 90, 91, 92) comporte un filtre (68, 70, 73, 75, 77), et en ce qu'au moins un trajet de fréquence (88, 89, 90, 91, 92) comporte au moins un diviseur de fréquence (66, 72), lequel assure une division par des facteurs de division entiers.

5. Appareil de mesure selon la revendication 3 ou 4,
**caractérisé**
**en ce qu'**un mélangeur (65) est agencé à l'intérieur d'au moins un trajet de fréquence (92),
**en ce que** le mélangeur (65) à l'intérieur du trajet de fréquence (92) mélange avec abaissement le signal du trajet de fréquence (92) à une fréquence d'horloge ou à un multiple d'une fréquence d'horloge.

6. Appareil de mesure selon l'une quelconque des revendications 1 à 5,
**caractérisé**
**en ce qu'**au moins un mélangeur (57) est agencé entre le dispositif à synthétiseur (49a, 49c) et les oscillateurs commandés (64, 64a, 64b, 64c, 64d), et
**en ce que** le mélangeur (57) mélange au moins un signal généré par le dispositif synthétiseur (49a, 49c) à un signal d'horloge ou à un multiple d'un signal d'horloge.

7. Appareil de mesure selon l'une quelconque des revendications 1 à 6,
**caractérisé**
**en ce que** le dispositif à synthétiseur (49a, 49c) convertit les signaux numériques avec une précision élevée,
**en ce qu'**au moins un convertisseur numérique-analogique (56) est agencé entre le dispositif à synthétiseur (49a, 49c) et les oscillateurs commandés (64, 64a, 64b, 64c, 64d),
**en ce que** le convertisseur numérique-analogique (56) convertit un signal généré par le dispositif à synthétiseur (49a, 49c) en signal analogique,
**en ce que** le convertisseur numérique-analogique (56) dispose d'une précision de quantification inférieure à celle du dispositif à synthétiseur (49a, 49c),
**en ce qu'**au moins un dispositif de tramage (52a, 52b, 52c, 52d) est monté en aval du dispositif à synthétiseur (49a, 49c), et
**en ce que** le dispositif de tramage (52a, 52b, 52c, 52d) réalise un tramage au moins d'un signal généré par le dispositif à synthétiseur (49a, 49c).

8. Procédé comprenant le fonctionnement d'un appareil de mesure selon la revendication 1.

9. Procédé selon la revendication 8,
**caractérisé**
**en ce que** les signaux générés par les oscillateurs commandés (64, 64a, 64b, 64c, 64d) sont traités par les dispositifs de division de fréquence (82, 82a, 82b, 82c, 82d).

10. Procédé selon la revendication 9,
**caractérisé**
**en ce que** chaque dispositif de division de fréquence (82, 82a, 82b, 82c, 82d) comporte plusieurs trajets de fréquence (87, 88, 89, 90, 91, 92) différents pour des signaux de différentes plages de fréquences,
**en ce que** chaque trajet de fréquence (87, 88, 89, 90, 91, 92) comporte un dispositif de commutation (67, 69, 71, 74, 76, 78), et
**en ce qu'**un seul trajet de fréquence est commuté sur une sortie de signal (81) commune par le dispositif de commutation (67, 69, 71, 74, 76, 78).

11. Procédé selon la revendication 10,
**caractérisé**
**en ce que** les signaux sont filtrés sur au moins un trajet de fréquence (88, 89, 90, 91, 92), et
**en ce que** les fréquences des signaux sont divisées sur au moins un trajet de fréquence (88, 89, 90, 91, 92) par un facteur de division entier.

12. Procédé selon la revendication 10 ou 11,
**caractérisé**
**en ce que** les signaux d'au moins un trajet de fréquence (92) sont mélangés avec abaissement à une fréquence d'horloge ou à un multiple d'une fréquence d'horloge.

13. Procédé selon l'une des revendications 8 à 12,
**caractérisé**
**en ce que** les signaux générés par le dispositif à synthétiseur (49a, 49c) sont mélangés à un signal d'horloge ou à un multiple d'un signal d'horloge.

14. Procédé selon l'une quelconque des revendications 8 à 13,
**caractérisé**
**en ce que** des signaux numériques sont générés par le dispositif à synthétiseur (49a, 49c) avec une précision élevée,
**en ce que** les signaux générés par le dispositif à synthétiseur (49a, 49c) sont soumis à une conversion numérique-analogique,
**en ce que** la conversion numérique-analogique dispose d'une précision inférieure à celle de la génération des signaux par le dispositif à synthétiseur (49a, 49c), et
**en ce que** les signaux générés par le dispositif à synthétiseur (49a, 49c) sont soumis à un tramage.
